(19) **Europäisches Patentamt**

**European Patent Office**

**Office européen des brevets**

(11) **EP 0 963 039 B1**

(12) **FASCICULE DE BREVET EUROPEEN**

(45) Date de publication et mention
de la délivrance du brevet:
**07.04.2004 Bulletin 2004/15**

(51) Int Cl.⁷: **H03G 3/00**

(21) Numéro de dépôt: **99201671.7**

(22) Date de dépôt: **26.05.1999**

(54) **Dispositif radiofréquence incluant un circuit amplificateur de puissance avec un circuit stabilisateur, et terminal mobile d'émission-réception incluant un tel dispositif**

Hochfrequenzvorrichtung mit Leistungsverstärker mit Stabilisierschaltung und mobiles Telefonendgerät mit einer solchen Vorrichtung

Radio-frequency device comprising a power amplifier circuit with a stabilising circuit, and a transmit-receive mobile terminal incorporating such a device

(84) Etats contractants désignés:
**DE FR GB IT**

(30) Priorité: **03.06.1998 FR 9806965**

(43) Date de publication de la demande:
**08.12.1999 Bulletin 1999/49**

(73) Titulaire: **Koninklijke Philips Electronics N.V.
5621 BA Eindhoven (NL)**

(72) Inventeurs:
• **Jean, Patrick, Société Civile S.P.I.D.
75008 Paris (FR)**
• **Talbot, Pascal, Société Civile S.P.I.D.
75008 Paris (FR)**

(74) Mandataire: **Lottin, Claudine
Société Civile SPID,
156, Boulevard Haussmann
75008 Paris (FR)**

(56) Documents cités:
**US-A- 4 547 746      US-A- 5 532 648**

## Description

### FIELD OF THE INVENTION

L'invention concerne un dispositif radiofréquence incluant un circuit amplificateur de puissance ayant une entrée et une sortie pour des signaux radiofréquences et ayant des bornes d'alimentation en continu, et incluant un circuit stabilisateur de puissance pour commander des variations de la puissance du signal de sortie radiofréquences de l'amplificateur de puissance en fonction de variations d'une tension de référence.

L'invention concerne également un terminal mobile d'émission-réception incluant un tel dispositif, et en particulier un terminal mobile cellulaire.

On rappelle que dans un terminal mobile d'émission - réception, il est nécessaire d'associer au circuit émetteur-récepteur un circuit qui permet de faire varier la puissance d'émission dans des limites en fonction d'une tension de référence variable. En effet, un terminal mobile d'émission - réception coopère avec une station de base dont la distance au terminal mobile varie lorsque l'utilisateur du terminal mobile se déplace. La puissance d'émission du terminal mobile pour que la station de base effectue une réception correcte dépend de cette distance. Un protocole généré par la station de base est en mesure d'informer le terminal mobile du niveau de puissance approprié que le système d'émission du terminal mobile doit fournir pour éviter la saturation du système de réception de la station de base, compte tenu de cette distance. Le terminal mobile doit donc comporter un circuit de contrôle de la puissance émise pour que cette puissance corresponde à la puissance appropriée requise par la station de base.

Un terminal mobile cellulaire est à ce jour un appareil grand public d'émission - réception que le concepteur cherche à réaliser aussi peu encombrant que possible, et d'un coût aussi faible que possible, pour une utilisation attrayante, courante et facile. Les circuits introduits dans le boîtier du terminal mobile doivent donc être petits, peu onéreux et très fiables.

### BACKGROUND OF THE INVENTION

Il est déjà connu de la publication : « Integrated Circuit Technology Options for RFIC's -Present Status and Future Directions » p.387-389 dans IEEE Journal of SOLID-STATE CIRCUITS, Vol.33, NO. 3, March 1998, par Lawrence E. Larson, un dispositif incluant un stabilisateur de puissance d'un circuit amplificateur de puissance qui opère par le contrôle de la tension d'alimentation en continu. Ce dispositif comprend un circuit amplificateur de puissance dont la sortie est reliée au moyen d'un coupleur à une antenne et à un détecteur de puissance. Ce dispositif comprend en outre un amplificateur de contrôle qui reçoit une tension continue de contrôle externe appelée référence et qui applique une tension continue de consigne sur un étage fournissant la tension d'alimentation en continu. Le détecteur de puissance fournit également une tension d'entrée à l'amplificateur de contrôle. Ainsi la tension d'alimentation de l'amplificateur de puissance est asservie par une boucle à une valeur telle qu'il y a concordance entre l'information fournie par le détecteur de puissance et la tension de consigne qui correspond à la tension de contrôle. Dans un terminal mobile, la tension de contrôle est reçue par un processeur qui répète la tension de référence émise par la station de base.

### SUMMARY OF THE INVENTION

Un problème est que ce dispositif incluant les circuits stabilisateur et amplificateur de puissance présente en général des mauvaises performances dues aux dispersions dans la réalisation industrielle des éléments de circuits. En particulier l'amplificateur de puissance présente des caractéristiques très dispersées. A titre d'exemple, certains amplificateurs peuvent fournir une puissance de 1W, alors que d'autres peuvent fournir une puissance de 1,5W pour une même tension d'alimentation continue. Un autre problème est que ce dispositif nécessite la présence d'un coupleur qui est un élément volumineux et peu fidèle. Dû à ces problèmes ce dispositif connu n'est pas correctement approprié à l'application dans un terminal mobile.

L'invention a pour but de fournir un dispositif incluant un circuit stabilisateur de puissance pour un circuit amplificateur de puissance qui est exempt de ces problèmes. En particulier la présente invention a pour but de fournir un dispositif dont la puissance sortie est indépendante de la dispersion de fabrication des éléments de circuit, et qui ne nécessite pas l'utilisation d'un coupleur.

Selon l'invention ce but est atteint et les problèmes sont résolus avec un dispositif selon la revendication 1.

Ce dispositif est fondé sur l'évaluation du rendement de l'amplificateur de puissance qui est une caractéristique stable, peu influencée par les dispersions de fabrication de l'amplificateur de puissance. Il en résulte l'avantage que la puissance de sortie de l'amplificateur est bien contrôlée. De plus ce dispositif présente l'avantage d'être simple et compact.

### BRIEF DESCRIPTION OF THE DRAWINGS

L'invention est décrite ci-après en détail en référence aux figures schématiques annexées dont :

la FIG.1A qui représente sous forme simplifiée un dispositif radiofréquence avec un circuit amplificateur de puissance et un circuit stabilisateur, la FIG. 1B qui est un schéma équivalent au dispositif de la FIG.1A, et la FIG.1C qui représente le dispositif de la FIG.1A avec des systèmes de polarisation et contre-réaction des circuits ;

les FIGs.2A et 2B qui représentent des caractéristiques du circuit amplificateur ;

la FIG.3 qui représente les variations de la puissance consommée dans les amplificateurs de puissance en fonction du coefficient de dispersion en fabrication ;

la FIG.4 qui représente un dispositif avec un circuit radiofréquence émetteur-récepteur ;

la FIG.5 qui représente un dispositif terminal mobile émetteur-récepteur avec un dispositif selon l'une des FIGs.1A à 1C, ou selon la FIG.4.

## DESCRIPTION OF THE PREFERRED EMBODIMENTS

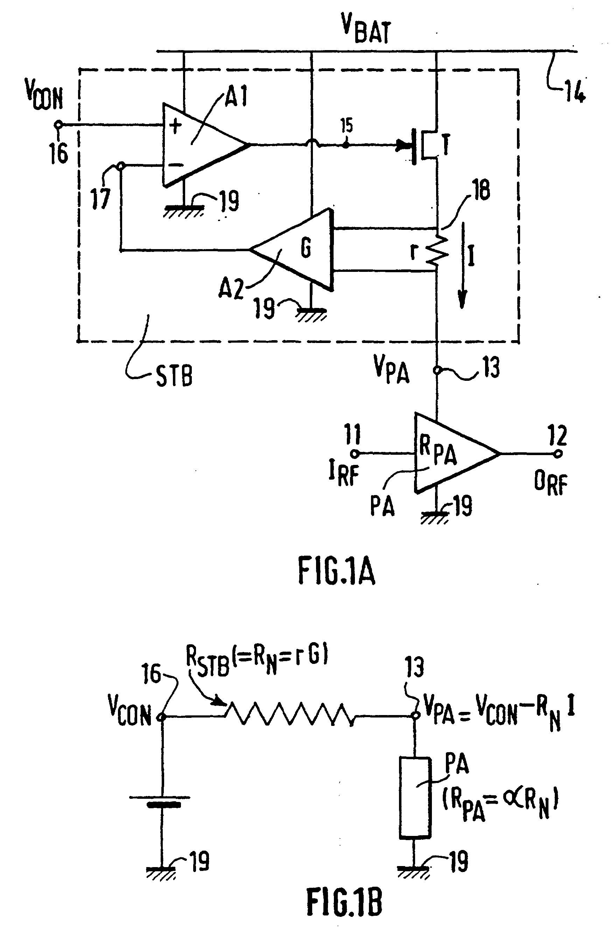

En référence à la FIG.1A, l'invention concerne un dispositif radiofréquences incluant un circuit amplificateur de puissance PA, et un circuit stabilisateur STB pour régler, contrôler et stabiliser la puissance de sortie notée $P_{OUT}$ du circuit amplificateur de puissance PA en fonction d'une tension continue de valeur variable $V_{CON}$ appelée tension de consigne imposée par un circuit annexe non représenté.

Le circuit amplificateur de puissance PA est alimenté en continu par une tension $V_{PA}$ appliquée entre le noeud 13 et la masse 19. L'amplificateur de puissance PA a une résistance interne $R_{PA}$. Cet amplificateur comprend par ailleurs une entrée 11 pour un signal d'entrée radiofréquence $I_{RF}$ et une sortie 12 pour un signal radiofréquence amplifié $O_{RF}$ qui a la puissance de sortie $P_{OUT}$.

La puissance de sortie $P_{OUT}$ de l'amplificateur de puissance PA au noeud 12 doit être une fonction qui varie en correspondance avec la tension de consigne $V_{CON}$. Le circuit stabilisateur STB a pour fonction de régler la puissance de sortie $P_{OUT}$ de l'amplificateur de puissance PA en fonction de la tension continue de consigne $V_{CON}$.

Un problème est que, pour une application envisagée du dispositif émetteur-récepteur à un terminal mobile, les circuits doivent être très compacts. Un autre problème est que, d'une manière générale, l'amplificateur de puissance PA montre des dispersions de performances dues à la fabrication, ce qui rend difficile le réglage de la puissance de sortie en fonction d'une tension de consigne.

En référence à la FIG.1A, le circuit stabilisateur de puissance STB appliqué à l'amplificateur de puissance PA permet de résoudre ces problèmes. Ce circuit stabilisateur STB de la FIG.1A comporte un premier amplificateur A1 ayant une première entrée 16 pour un signal continu à la tension de consigne positive $V_{CON}$ et une deuxième entrée 17 négative pour une tension fournie par la sortie d'un second amplificateur A2. En 14, on trouve une tension d'alimentation continue fixe $V_{BAT}$ qui alimente les deux amplificateurs A1 et A2. La tension d'alimentation continue $V_{BAT}$ est généralement générée par une batterie disposée dans un boîtier abritant le dispositif ou bien par un système transformateur alimenté par un réseau de distribution de courant. D'autres manières de générer $V_{BAT}$ sont à la portée de l'homme du métier, sans limitation. Le circuit stabilisateur STB comprend en outre un étage à transistor T, par exemple un transistor MOS T, travaillant en résistance variable. Ce transistor T reçoit sur son électrode de grille la tension continue de sortie 15 de l'amplificateur A1. Son électrode de drain est connectée en 14 à la tension d'alimentation continue $V_{BAT}$ et son électrode de source est connectée en 18 à une entrée positive du second amplificateur A2. Une seconde entrée négative 13 de ce second amplificateur A2 est telle qu'une tension continue $V_{PA}$ se trouve sur le noeud 13. A cet effet :

le second amplificateur A2 a un gain G,
une résistance r de faible valeur est connectée entre le noeud 18 commun à la source du transistor T et à l'entrée positive du second amplificateur A2, et le noeud 13 qui est l'entrée négative de ce second amplificateur A2 et en même temps la borne d'alimentation continue $V_{PA}$ de l'amplificateur de puissance PA.

Ainsi agencé, le circuit stabilisateur STB forme une boucle entre l'entrée 16 pour la tension de consigne $V_{CON}$ et le noeud 13 où la tension d'alimentation continue $V_{PA}$ de l'amplificateur de puissance PA est disponible.

Le circuit de la FIG.1A a pour circuit équivalent le schéma de la FIG.1B. Ce circuit équivalent comprend un générateur de tension entre les noeuds 16 et 19 qui génère la tension de consigne $V_{CON}$, une résistance équivalente au circuit stabilisateur notée $R_{STB}$ qui est telle que :

$$R_{STB} = r \times G,$$

à laquelle on donne une valeur spécifique :

$$R_{STB} = R_N,$$

dans laquelle circule un courant I et qui est connectée entre les noeuds 16 et 13. L'amplificateur de puissance PA est équivalent à une impédance de charge $R_{PA}$ de valeur égale à sa résistance interne, connectée entre les noeuds 13 et 19, dans laquelle circule également le courant I. En 13, on trouve la tension d'alimentation continue $V_{PA}$ pour l'amplificateur de puissance PA.

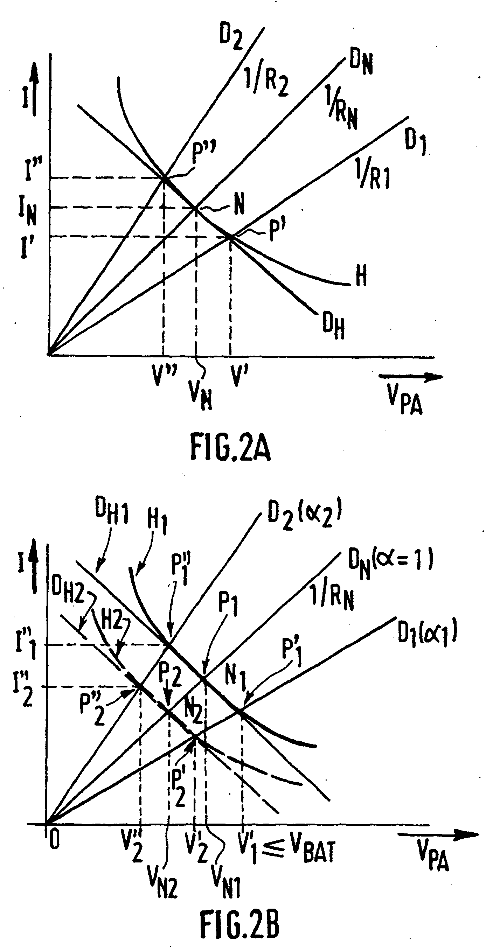

La FIG.2A représente des caractéristiques de courant I en fonction de la tension $V_{PA}$ de l'amplificateur de puissance travaillant en régime de saturation. Ces caractéristiques sont dans ce cas approximativement des droites. On a représenté une première caractéristique moyenne appelée caractéristique nominale sous la forme de la droite $D_N$ pour un amplificateur consommant une puissance moyenne notée $P_{PA}$, cet amplificateur étant appelé amplificateur de puissance moyen sortant de fabrication. Pour déterminer la caractéristique nominale $D_N$ d'un amplificateur de puissance PA moyen, on a par exemple réalisé des statistiques sur un lot d'amplificateurs de puissance lors d'un travail de pré-développement de leur fabrication. La pente de la caractéristique nominale $D_N$ est égale à $1/R_N$ où $R_N$ est la valeur de la résistance nominale interne d'un amplificateur moyen, telle que $R_{PA} = R_N$, déterminée par une telle étude statistique. Ultérieurement, cette caractéristique nominale $D_N$ et cette résistance nominale $R_N$ sont prises comme références.

Du fait des dispersions de fabrication, on peut trouver des amplificateurs PA consommant des puissances plus faibles qui montrent une caractéristique $D_1$, ou bien des amplificateurs PA consommant des puissances plus fortes qui montrent une caractéristique $D_2$. Les pentes des caractéristiques $D_1$, $D_2$ sont égales respectivement $1/R_1$, $1/R_2$, où $R_1$, $R_2$ sont les résistances internes des amplificateurs de puissance ayant pour caractéristiques respectives $D_1$, $D_2$. L'amplificateur de caractéristique $D_1$ consomme un courant I' qui est inférieur au courant $I_N$ consommé par l'amplificateur moyen de caractéristique nominale $D_N$. Et l'amplificateur de caractéristique $D_2$ consomme un courant I" qui est supérieur au courant $I_N$ consommé par cet amplificateur moyen de caractéristique nominale $D_N$. Donc pour une même tension $V_{PA}$ donnée, l'amplificateur de caractéristique $D_1$ consomme moins de puissance, et l'amplificateur de caractéristique $D_2$ consomme davantage de puissance que l'amplificateur moyen de caractéristique nominale $D_N$.

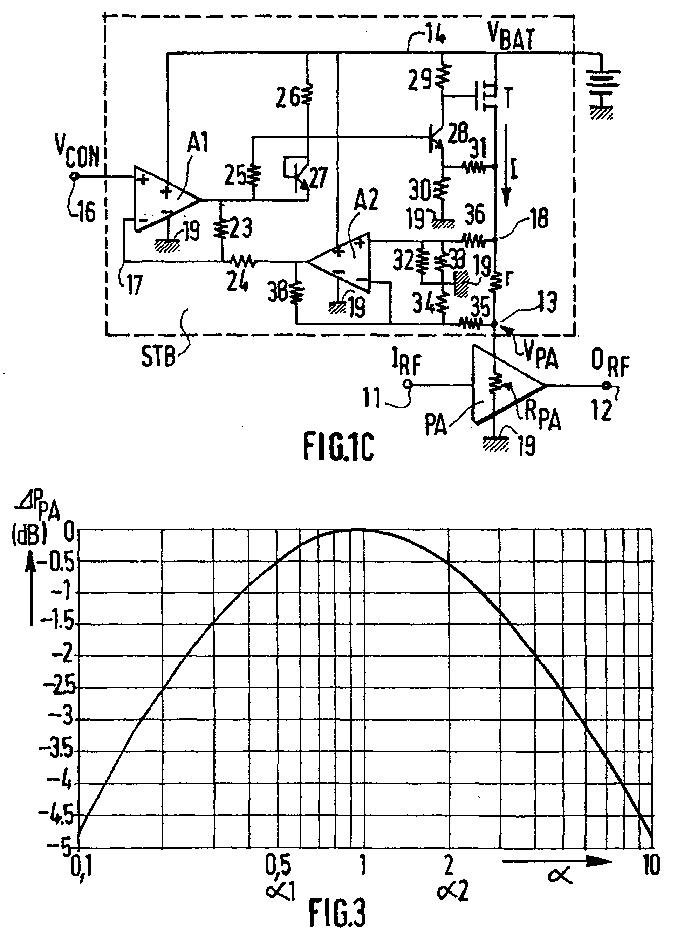

La FIG.3 montre une courbe représentative de la différence de puissance consommée $\Delta P_{PA}$ par un amplificateur PA quelconque pris au hasard dans un lot de fabrication par rapport à l'amplificateur moyen, en fonction d'un coefficient multiplicatif $\alpha$ appelé coefficient de dispersion qui, multiplié à la résistance nominale $R_N$ donne la résistance interne $R_{PA}$ de l'amplificateur quelconque considéré :

$$R_{PA} = \alpha\, R_N$$

Sur la courbe de la FIG.3, à titre d'exemple, on peut déterminer qu'une différence possible de puissance consommée $\Delta P_{PA} = 0{,}5$ dB par rapport à la puissance consommée moyenne correspond à un coefficient $\alpha$ compris entre $\alpha_1 = 0{,}5$ et $\alpha_2 = 2$. Lorsque le coefficient $\alpha = 1$, on trouve $\Delta P_{PA} = 0$, ce qui correspond à l'amplificateur de puissance moyen ayant une caractéristique nominale $D_N$ et une résistance nominale $R_N$.

Selon l'invention, le circuit de la FIG.1A ne comporte pas de détecteur de puissance. Ceci permet d'éviter des inconvénients signalés relativement au circuit décrit à titre d'art antérieur. On rappelle que la puissance de sortie $P_{OUT}$ d'un amplificateur de puissance PA de caractéristique quelconque, pris dans le lot de fabrication, est reliée à la puissance consommée $P_{PA}$ à l'intérieur de cet amplificateur de puissance PA par une valeur de rendement $\gamma$ tel que le rendement :

$$\gamma = P_{OUT}/P_{PA}$$

Il faut savoir que, dans le type d'amplificateur de puissance PA utilisé dans les circuits intégrés hyperfréquences, tels que les circuits des FIG.1A à 1C, le rendement $\gamma$ est substantiellement constant quel que soit l'amplificateur de puissance PA pris dans un lot de fabrication.

Selon l'invention, les éléments du circuit stabilisateur STB sont déterminés pour stabiliser la puissance $P_{PA}$ consommée par l'amplificateur de puissance PA. Ainsi le circuit STB de la FIG.1A permet que la puissance consommée dans l'amplificateur de puissance PA soit substantiellement indépendante des dispersions de fabrication, c'est-à-dire constante, quel que soit l'amplificateur de puissance PA d'un lot de fabrication, pour une tension de consigne $V_{CON}$ donnée. Donc grâce au circuit STB, la puissance $P_{PA}$ consommée par l'amplificateur de puissance PA est constante et comme le rendement $\gamma$ est constant, il en résulte que la puissance de sortie $P_{OUT}$ est constante quelles que soient les dispersions de fabrication de l'amplificateur de puissance, pour une tension de consigne $V_{CON}$ donnée. Au moyen du circuit de stabilisation STB, pour une tension de consigne donnée $V_{CON}$, la puissance de sortie $P_{OUT}$ de l'amplificateur de puissance PA est rendue constante quels que soient sa résistance interne $R_{PA}$, sa caractéristique D, et le coefficient de dispersion $\alpha$ pris dans des limites prédéterminées $\alpha_1$, $\alpha_2$.

Ce but est atteint en construisant le circuit stabilisateur STB avec une résistance interne équivalente :

$$R_{STB} = r \times G = R_N$$

comme il est démontré ci-après.

La puissance consommée $P_{PA}$ dans l'amplificateur de puissance PA est directement liée à sa tension d'alimentation $V_{PA}$ au noeud 13, et au courant I qui circule dans l'amplificateur de puissance PA dans la branche 13, 19. Le circuit stabilisateur STB permet de régler efficacement cette tension d'alimentation $V_{PA}$ et ce courant I. La puissance consommée dans l'amplificateur de puissance PA est alors constante lorsque le produit du courant I qui traverse cet amplificateur de puissance PA par la tension d'alimentation continue $V_{PA}$ à ses bornes est constant :

$$P_{PA} = V_{PA} \times I$$

Le circuit de stabilisation STB forme une boude qui garantit que la puissance consommée dans l'amplificateur PA est constante quel que soit $\alpha$. Comme le rendement d'un amplificateur de puissance PA est substantiellement constant, il en résulte qu'en asservissant la puissance consommée dans l'amplificateur de puissance PA, on garantit que la puissance de sortie $P_{OUT}$ du signal radiofréquence $O_{RF}$ est constante.

Dans le circuit de la FIG.1A, l'amplificateur de puissance PA est connecté entre les bornes 13 et 19 pour être alimenté en continu par la tension $V_{PA}$ qui règle la puissance consommée $P_{PA}$ égale au produit du courant I par la tension $V_{PA}$ en question.

En référence à la FIG.1B, la résistance équivalente au circuit stabilisateur $R_{STB}$ est parcourue par le courant I et la chute de tension dans cette résistance est le produit $R_N I$. Il en résulte que la tension d'alimentation de l'amplificateur de puissance au noeud 13 est donnée par :

$$V_{PA} = V_{CON} - R_N\ I.$$

En référence à la FIG.2A, le lieu où le produit du courant par la tension est exactement constante est une hyperbole représentée par la courbe H qui est appelée hyperbole des isopuissances. Les intersections de l'hyperbole H et des caractéristiques $D_1$, $D_N$, $D_2$ des amplificateurs de puissance PA définissent des couples de valeurs courant - tension I',$V'_{PA}$; $I_N$,$V_{NPA}$ et I", $V"_{PA}$ tels que la puissance consommée, qui est le produit des valeurs courant - tension de chaque couple est exactement constante.

Pour mettre en oeuvre le circuit de la FIG.1A, on considère une droite $D_H$ tangente à l'hyperbole H au point N qui est l'intersection de la caractéristique nominale $D_N$ et de l'hyperbole H des isopuissances. Cette droite $D_H$ définit par intersection avec les caractéristiques $D_1$ et $D_2$ des couples de valeurs courant - tension qui sont substantiellement confondus avec les couples de valeurs courant - tension I', $V'_{PA}$ et I", $V"_{PA}$ dans les conditions où les caractéristiques D1, D2 correspondent à des coefficients de dispersion pris dans des limites prédéterminées $\alpha_1$, $\alpha_2$. On considère donc que la droite $D_H$ tangente à l'hyperbole H des isopuissances est une bonne approximation de cette hyperbole H sur le segment limité par les points $P'_{PA}$, $P"_{PA}$, qui sont situés à l'intersection de ces caractéristiques $D_1$, $D_2$ et de la droite $D_H$ et qui correspondent à des coefficients de dispersion extrêmes acceptables $\alpha$ 1, $\alpha$ 2. Ce segment sur la droite $D_H$ est un lieu où la puissance consommée $P_{PA}$ dans les amplificateurs de puissance PA est substantiellement constante.

En utilisant l'approximation définie par la droite $D_H$, et plus particulièrement par le segment délimité par D1, D2, on définit les éléments du circuit stabilisateur STB pour obtenir que la puissance consommée $P_{PA}$ dans l'amplificateur de puissance PA :

soit constante, pour une tension de consigne $V_{CON}$ donnée, quelle que soit la dispersion de fabrication de l'amplificateur de puissance, dans des limites $\alpha1$, $\alpha2$ connues ou voulues concrétisées par les caractéristiques $D_1$, $D_2$,
soit en concordance avec la tension de consigne $V_{CON}$ appliquée à l'entrée 16 de ce circuit stabilisateur STB.

En référence à la FIG.1B, on rend égale à la valeur nominale $R_N$ la résistance équivalente au circuit stabilisateur, notée $R_{STB}$, qui est disposée entre les noeuds 16 et 13, afin d'engendrer un courant I dans la branche 14, 13 du circuit stabilisateur STB et un même courant I dans la branche 13, 19 du circuit amplificateur de puissance. On choisit une valeur très faible pour la résistance r, appelée petite résistance, connectée entre les noeuds 18 aux bornes de l'amplificateur $A_2$ de gain G, de manière à ce que :

$$R_N = r \text{ x } G$$

En référence à la FIG.2B, lorsque la tension de consigne $V_{CON}$ change, les courbes isopuissances se déplacent. D'une part, pour une première tension de consigne $V_{CON}$ à une première valeur la courbe d'isopuissance exacte est l'hyperbole $H_1$ et la droite d'isopuissance approchée est la tangente $D_{H1}$. D'autre part, pour une deuxième tension de consigne $V_{CON}$ la courbe d'isopuissance exacte est l'hyperbole $H_2$ et la droite d'isopuissance approchée est la tangente $D_{H2}$. On note que la tension $V_{PA}$ ne peut excéder la valeur de la tension de batterie $V_{BAT}$.

De la FIG.2B, on déduit que pour des tensions de consigne $V_{CON}$ données, l'amplificateur de puissance PA consomme respectivement des puissances $P_1$, $P_2$, etc en concordance avec les tensions de consignes et qui sont constantes entre les limites de dispersions exprimées par les coefficients $\alpha_1$, $\alpha_2$ correspondant aux caractéristiques $D_1$, $D_2$. A titre d'exemple :

Sur $D_{H1}$, entre $\alpha_1$ et $\alpha_2$, $P'_1 = P"_1 = P_1$

Sur $D_{H2}$, entre $\alpha_1$ et $\alpha_2$, $P'_2 = P"_2 = P_2$

En référence à la FIG.1C, à titre d'exemple de mise en oeuvre pratique, le circuit stabilisateur STB de la FIG.1A comporte :

un étage de puissance pour générer un courant I de valeur suffisante au fonctionnement de l'amplificateur de puissance PA, incluant le transistor T de type P-MOS, un transistor 28 et des résistances 29, 30 et 31,
un étage de compensation en température de l'étage de puissance incluant un transistor 27 monté en diode, une résistance de polarisation 26 et une résistance de contre-réaction 25,

un étage amplificateur A1, avec l'entrée 16 pour la tension de consigne $V_{CON}$, une résistance de contre-réaction 23 et une résistance de liaison 24,

un étage amplificateur A2 de gain G, avec une résistance de contre-réaction 38, une sortie 17 reportée sur l'entrée de l'amplificateur A1, et une contre-réaction formée du pont de résistances 32, 33 et 34 d'une part et 35, 36 d'autre part, dont les valeurs doivent être accordée en fonction de la résistance 38, et avec, entre les noeuds 13 et 18, la résistance r de valeur 0,1Ω, parcourue par le courant I.

Le tableau suivant donne les valeurs des résistances de cet exemple de mise en oeuvre :

| N° des résistances | valeur en ohms |
|---|---|
| 25, 33, 34, 35, 36 | 10 k Ω |
| 32, 38 | 220 k Ω |
| 23 | 15 k Ω |
| 26 | 47 k Ω |
| 29 | 1 k Ω |
| 24 | 18 k Ω |
| 30 | 47 Ω |
| 31 | 220 Ω |

La résistance interne de l'amplificateur de puissance PA est de l'ordre de 10 Ω, la tension $V_{BAT}$ en 14 est de l'ordre de 3,6 V. Cette tension alimente l'étage de puissance avec T, l'étage compensateur de température, l'étage amplificateur A1 et l'étage amplificateur A2 de gain G. La tension $V_{PA}$ en 13 est de l'ordre de 3,5V.

En choisissant la valeur de la résistance r petite, par exemple quelques 0,1Ω, ou bien de l'ordre de $R_N/20$ à $R_N/200$, par exemple avec RN de l'ordre de 10 Ω, on obtient que la puissance consommée dans le circuit stabilisateur STB soit très faible, et que la chute de tension dans la branche 14, 13 entre $V_{BAT}$ et $V_{PA}$ soit très petite. Il en résulte que, par exemple, avec une batterie de 3,6V on peut alimenter l'amplificateur de puissance PA avec une tension $V_{PA}$ de l'ordre de 3,5V. Ceci représente une économie importante de puissance consommée dans l'ensemble des circuits de la FIG.1A. En effet si la résistance entre $V_{BAT}$ et $V_{PA}$ était réellement $R_N$, alors la tension $V_{BAT}$ devrait être de plus de 6V dans cet exemple, et la puissance consommée dans l'ensemble des circuits de la FIG.1A serait pratiquement doublée. Le circuit stabilisateur réalisé selon l'invention présente donc un avantage important.

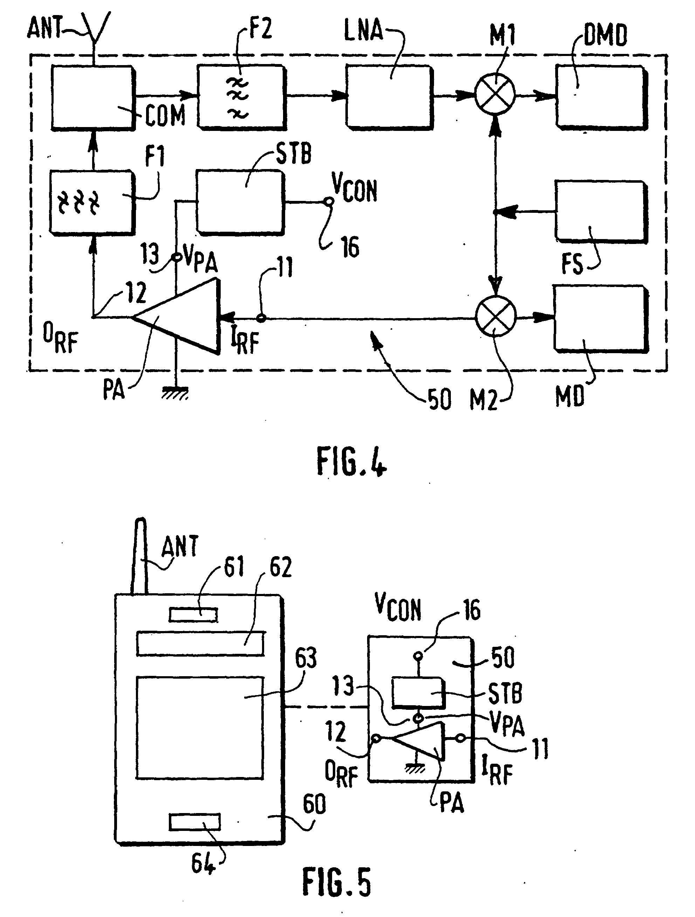

La FIG.4 montre à titre d'exemple non limitatif un dispositif radiofréquence émetteur-récepteur incluant un amplificateur de puissance PA et un stabilisateur STB comme décrits en référence aux FIG.1A ou 1C. Ce dispositif 50 comprend une antenne ANT, une boucle avec un filtre F2, un amplificateur bas bruit LNA, un mélangeur M1, un démodulateur DMD, un synthétiseur de fréquences FS, un modulateur MD, un second mélangeur M2 une borne 11 pour le signal radiofréquence d'entrée IRF provenant de M2, un amplificateur de puissance PA avec une sortie 12 pour le signal radiofréquences de sortie ORF, un stabilisateur STB avec une entrée 16 pour le signal de consigne VCON et une borne 13 pour appliquer la tension d'alimentation VPA sur l'amplificateur de puissance PA, un filtre F1, et un commutateur COM relié aux deux filtres F1, F2 et à l'antenne ANT. Le fonctionnement d'un tel circuit radiofréquence est bien connu de l'homme du métier et en particulier de la publication citée à titre d'état de la technique, avec bien entendu la différence fondamentale de l'amplificateur de puissance PA et du stabilisateur STB selon l'invention.

Un tel circuit est de préférence intégré dans une technologie permettant le fonctionnement en hyperfréquences. Une technologie avantageuse de réalisation de ces circuits intégrés est la technologie mettant en oeuvre l'arséniure de gallium (GaAs).

La FIG.5 représente un dispositif terminal mobile avec un boîtier 60 pour abriter un dispositif 50 radiofréquences avec un amplificateur de puissance PA et un stabilisateur STB selon l'invention. Le dispositif 50 peut être avantageusement un circuit intégré, et en particulier un circuit intégré en technologie GaAs. Le boîtier comprend une antenne ANT, une fonction écouteur ou haut-parleur 61, une fonction microphone 64, une zone 63 de touches de commande, et une zone d'affichage 62.

## Revendications

**1.** Dispositif radiofréquence incluant un circuit amplificateur de puissance (PA) ayant une entrée et une sortie (11, 12) pour des signaux ($I_{RF}$, $O_{RF}$) radiofréquence et ayant des bornes (13, 19) d'alimentation en continue ($V_{PA}$), et incluant un circuit stabilisateur (STB) pour commander des variations de la puissance du signal de sortie radiofréquences ($O_{RF}$) de l'amplificateur de puissance en fonction de variations d'une tension de consigne ($V_{CON}$), **caractérisé en ce que** le circuit stabilisateur est agencé pour être équivalent à une résistance appelée nominale ($R_N$) de valeur prédéterminée en fonction d'une courbe d'isopuissance spécifique (H, $D_H$) de l'amplificateur de puissance, et pour générer sur la borne (13) d'alimentation continue dudit amplificateur de puissance une tension ($V_{PA}$) en dépendance de la tension de consigne ($V_{CON}$) et de ladite résistance nominale ($R_N$), en sorte que la puissance ($P_{PA}$) consommée dans l'amplificateur de puissance (PA) est en concordance avec ladite tension de consigne ($V_{CON}$) de manière indépendante de la résistance interne réelle ($R_{PA}$) de l'amplificateur de puissance, et en sorte qu'il en est de même de la puissance de sortie ($P_{OUT}$) de l'amplificateur de puissance ($P_A$) qui est proportionnelle à la puissance consommée ($P_{PA}$) par un facteur de rendement substantiellement fixe.

2. Dispositif selon la revendication 1, **caractérisé en ce que** le drcuit stabilisateur (STB) est équivalent à ladite résistance nominale ($R_N$) qui est disposée entre une borne recevant ladite tension de consigne ($V_{CON}$) et une borne (13) d'alimentation en continu du circuit amplificateur de puissance, en sorte que la tension d'alimentation continue ($V_{PA}$) du circuit amplificateur de puissance générée sur ladite borne (13) est égale à la tension de consigne ($V_{CON}$) diminuée de la chute de tension dans cette résistance ($R_N$) nominale qui est traversée par le courant (I) de travail du circuit amplificateur.

3. Dispositif selon la revendication 2, **caractérisé en ce que** le circuit stabilisateur (STB) est agencé en boucle entre la borne (16) recevant la tension de consigne ($V_{CON}$) et la borne (13) de tension d'alimentation de l'amplificateur de puissance avec des moyens de réduction de la consommation de puissance dans ce circuit stabilisateur proprement dit.

4. Dispositif selon la revendication 3, **caractérisé en ce que** les moyens de réduction de la consommation de puissance dans le circuit stabilisateur proprement dit (STB) comprennent une branche (14-13) connecté d'une part à une batterie (14) fournissant une tension d'alimentation continue ($V_{BAT}$) pour le circuit stabilisateur (STB), et d'autre part à la borne (13) d'alimentation continue ($V_{PA}$) de l'amplificateur de puissance (PA), cette branche étant parcourue par le courant de travail (I) de l'amplificateur de puissance, et comprenant montés en série une transistor (T) à fonction de résistance variable et une petite résistance (r) ayant une valeur substantiellement faible devant ladite résistance nominale ($R_N$) dans une fourchette 1/20 à 1/200.

5. Dispositif selon la revendication 4, **caractérisé en ce que** le circuit stabilisateur monté en boucle comprend dans une première branche un premier amplificateur (A1) qui reçoit la tension de consigne ($V_{CON}$) et qui contrôle la résistance du transistor (T) monté en résistance variable, et qui comprend dans une seconde branche un second amplificateur ayant un gain prédéterminé (G) dont les bornes d'entrée sont connectées aux bornes de ladite petite résistance (r) et dont la sortie est portée comme une seconde entrée sur le premier amplificateur (A1), le gain (G) du second amplificateur étant prédéterminé de sorte que le produit de ce gain( G) par la valeur de ladite petite résistance (r) est égal à la valeur de la résistance nominale ($R_N$).

6. Dispositif selon l'une des revendications 1 à 5, **caractérisé en ce que** la valeur de la résistance nominale ($R_N$) est la moyenne des résistances internes ($R_{PA}$) d'un lot de fabrication de circuits amplificateurs de même type.

7. Dispositif selon la revendication 6, **caractérisé en ce que** les amplificateurs de puissance du lot de fabrication pour réaliser le dispositif ont des coefficients de dispersion prédéterminés dans une fourchette ($\alpha_1$, $\alpha_2$) correspondant à des caractéristiques extrêmes courant-tension (D1,D2) autour de la caractéristique courant-tension nominale ($D_N$) correspondant à la résistance nominale ($R_N$), ces caractéristiques extrêmes (D1, D2) étant telles que les intersections des caractéristiques comprises entre ces caractéristiques extrêmes avec une droite ($D_H$) tangente à une courbe d'isopuissance exacte (H) au point d'intersection de cette courbe (H) et de la caractéristique nominale ($D_N$) déterminent des couples courant-tension substantiellement confondus avec les couples courant-tension qui sont situés sur la courbe d'isopuissance exacte (H), et que ladite droite tangente (DH) est une courbe d'isopuissance substantiellement exacte telle que les couples courant-tension de cette droite résultent en une puissance consommée par les amplificateurs quelconques du lot de fabrication qui est constante.

8. Dispositif selon l'une des revendications 1 à 7, incluant un circuit amplificateur de puissance et un circuit stabilisateur dans un circuit radio-fréquences émetteur-récepteur.

9. Dispositif selon la revendication 8, réalisé en technologie de circuits intégrés en arséniure de gallium (GaAs).

10. Dispositif terminal mobile d'émission-réception incluant un dispositif radiofréquence selon l'une des revendications 1 à 9.

## Patentansprüche

1. Hochfrequenzvorrichtung mit einer Leistungsverstärkerschaltung (PA) mit einem Eingang und einem Ausgang (11, 12) für Hochfrequenzsignale ($I_{rf}$, $O_{rf}$) und Gleichstrom-($V_{PA}$-)Versorgungsklemmen (13, 19) sowie mit einer Stabilisierschaltung (STB) zum Steuern der Leistungsvariationen des Hochfrequenz-Ausgangssignals ($O_{RF}$) des Leistungsverstärkers entsprechend den Variationen einer Vorgabespannung ($V_{CON}$), **dadurch gekennzeichnet, dass** die Stabilisierschaltung angeordnet ist, um äquivalent mit einem sogenannten nominalen Widerstand ($R_N$) vorbestimmten Werts unter Berücksichtigung einer spezifischen Isopotenz-Kurve (H, D$_H$) des Leistungsverstärker zu sein, und um an der Gleichstrom-Versorgungsklemme (13) des besagten Leistungsverstärker eine Spannung (V$_{PA}$) abgängig von der Vorgabespannung (V$_{CON}$) und vom besagten nominalen Widerstands (R$_N$) zu erzeugen, damit die im Leistungsverstärker (PA) aufgenommene Leistung (P$_{PA}$) mit der besagten Vorgabespannung (V$_{CON}$) vom reellen inneren Widerstand (R$_{PA}$) des Leistungsverstärkers auf unabhängige Weise konkordant ist und damit dies auch für die Ausgangsleistung (P$_{OUT}$) des Leistungsverstärkers (P$_A$) zutrifft, welche durch einen grundsätzlich festen Leistungsfaktor proportional zur aufgenommenen Leistung (P$_{PA}$) ist.

2. Vorrichtung nach Anspruch 1, **dadurch gekennzeichnet, dass** die Stabilisierschaltung (STB) äquivalent mit dem besagten nominalen Widerstand (R$_N$) ist, der zwischen einer Klemme angeordnet ist, welche die Vorgabespannung (V$_{CON}$) erhält, und einer Gleichstrom-Versorgungsklemme (13) der Leistungsverstärkerschaltung, womit die Gleichstrom-Versorgungsspannung (V$_{PA}$) der Leistungsverstärkerschaltung, welche an der besagten Klemme (13) erzeugt wird, gleich der Vorgabespannung (V$_{CON}$) ist, vermindert um den Spannungsabfall in diesem nominalen Widerstand (R$_N$), welcher vom Arbeitsstrom (I) der Verstärkerschaltung durchströmt wird.

3. Vorrichtung nach Anspruch 2, **dadurch gekennzeichnet, dass** die Stabilisierschaltung (STB) in Schleife zwischen der Klemme (16), welche die Vorgabespannung (V$_{CON}$) erhält, und der Klemme (13) der Versorgungsspannung des Leistungsverstärker mit Mitteln zur Verringerung der Leistungsaufnahme in der eigentlichen Stabilisierschaltung angeordnet ist.

4. Vorrichtung nach Anspruch 3, **dadurch gekennzeichnet, dass** die Mittel zur Verringerung der Leistungsaufnahme in der eigentlichen Stabilisierschaltung (STB) einen Zweig (14-13) enthalten, der einerseits an einen Akkumulator (14) angeschlossen ist, der eine Gleichstrom-Versorgungsspannung (V$_{BAT}$) für die Stabilisierschaltung (STB) liefert, und andererseits an die Gleichstrom-(V$_{BAT}$-)Versorgungsklemme (13) des Leistungsverstärker (PA), wobei diese Klemme vom Arbeitsstrom (I) des Leistungsverstärker durchquert wird, und einen in Serie geschalteten Transistor (T) aufweist, der als variabler Widerstand dient, und einen kleinen Widerstand (r) mit einem vor dem Nominalwiderstand (R$_N$) in einer Spanne von 1/20 bis 1/200 grundsätzlich geringen Wert.

5. Vorrichtung nach Anspruch 4, **dadurch gekennzeichnet, dass** die in Schleife angeordnete Stabilisierschaltung in einem ersten Zweig einen ersten Verstärker (A1) enthält, welcher die Vorgabespannung (V$_{CON}$) erhält und den Widerstand des als variablen Widerstand geschalteten Transistor (T) steuert, und in einem zweiten Zweig einen zweiten Verstärker mit einer vorbestimmten Leistung (G) aufweist, dessen Eingangsklemmen mit den Klemmen des besagten kleinen Widerstands (r) verbunden sind und dessen Ausgang wie ein zweiter Eingang an den ersten Verstärker (A1) übertragen ist, wobei die Leistung (G) des zweiten Verstärkers so vorbestimmt wird, dass das Produkt dieser Leistung (G) mit dem Wert des besagten kleinen Widerstands (r) gleich dem Wert des nominalen Widerstands (R$_N$) ist.

6. Vorrichtung nach einem der Ansprüche 1 bis 5, **dadurch gekennzeichnet, dass** der Wert des nominalen Widerstands (R$_N$) der Durchschnitt der inneren Widerstände (R$_{PA}$) einer Fertigungsserie von Verstärkerschaltungen selben Typs ist.

7. Vorrichtung nach Anspruch 6, **dadurch gekennzeichnet, dass** die Leistungsverstärker der Fertigungsserie für die Herstellung der Vorrichtung vorbestimmte Dispersionskoeffizienten innerhalb einer Spanne ($\alpha_1$, $\alpha_2$) entsprechend extremen Charakteristiken Strom-Spannung (D1, D2) um die Charakteristik Strom-Nominalspannung (D$_N$) entsprechend dem Nominalwiderstand (R$_N$) haben, wobei diese externem Charakteristiken (D1, D2) derart sind, dass die Schnittpunkte der zwischen diesen extremen Charakteristiken mit einer Geraden (D$_H$) tangential zu einer exakten Isopotenz-Kurve (H) am Schnittpunkt dieser Kurve (H) und der nominalen Charakteristik (D$_H$) enthaltenen Charakteristiken die Strom-Spannung-Paare bestimmen, die grundsätzlich mit den Strom-Spannung-Paaren konfundiert sind, welche auf der exakten Isopotenz-Kurve (H) liegen, und dadurch, dass die besagte gerade Tangente (DH) eine grundsätzlich exakte Isopotenz-Kurve ist, womit die Strom-Spannung-Paare dieser Geraden eine von beliebigen Verstärkern der Fertigungsserie aufgenommene Leistung ergeben, die konstant ist.

8. Vorrichtung nach einem der Ansprüche 1 bis 7, mit einer Leistungsverstärkerschaltung und einer Stabilisierschaltung in einer Sende-Empfangs-Hochfrequenzschaltung.

9. Vorrichtung nach Anspruch 8, gefertigt als integrierte Schaltung in Galliumarsenid-Technologie (GaAs).

10. Mobiles Sende-Empfangs-Endgerät mit einer Hochfrequenzvorrichtung nach einem der Ansprüche 1 bis 9.

**Claims**

1. A radio frequency device including a power amplifier circuit (PA) having an input and an output (11, 12) for radio frequency signals ($I_{RF}$, $O_{RF}$) and having terminals (13, 19) for DC power supply ($V_{PA}$), and including a stabilizer circuit (STB) for controlling variations of the power of the radio frequency output signal ($O_{RF}$) of the power amplifier as a function of variations of a reference voltage ($V_{CON}$), **characterized in that** the stabilizer circuit is arranged to be equivalent to a resistance called nominal resistance ($R_N$) having a predetermined value as a function of a specific isopower curve (H, $D_H$) of the power amplifier and to generate on the DC power supply terminal (13) of said power amplifier a voltage ($V_{PA}$) in dependence on the reference voltage ($V_{CON}$) and said nominal resistance ($R_N$), so that the power consumption ($P_{PA}$) in the power amplifier (PA) is in agreement with said reference voltage ($V_{CON}$) independently of the real internal resistance ($R_{PA}$) of the power amplifier, and so that the same applies to the output power ($P_{OUT}$) of the power amplifier (PA) which is proportional to the power consumption ($P_{PA}$) by a substantially fixed efficiency factor.

2. A device as claimed in claim 1, **characterized in that** the stabilizer circuit (STB) is equivalent to said nominal resistance ($R_N$) which is arranged between a terminal receiving said reference voltage ($V_{CON}$) and a DC supply terminal (13) of the power amplifier circuit, so that the DC supply voltage ($V_{PA}$) of the power amplifier having a power generated on said terminal (13) is equal to the reference voltage ($V_{CON}$) diminished by the voltage drop in this nominal resistance ($R_N$) which is passed through by the working current (I) of the amplifier circuit.

3. A device as claimed in claim 2, **characterized in that** the stabilizer circuit (STB) is arranged as a loop between the terminal (16) receiving the reference voltage ($V_{CON}$) and the supply voltage terminal (13) of the power amplifier with reducing means for reducing the power consumption in this actual stabilizer circuit.

4. A device as claimed in claim 3, **characterized in that** the means for reducing the power consumption in the actual stabilizer circuit (STB) comprise a branch (14-13) connected, on the one hand, to a battery (14) which produces a DC supply voltage ($V_{BAT}$) for the stabilizer circuit (STB), and on the other hand, to the terminal (13) for DC power supply ($V_{PA}$) of the power amplifier (PA), this branch being passed through by the working current (I) of the power amplifier, and including in a series combination a transistor (T) having the function of variable resistor and a small resistance (r) having a value substantially low compared with said nominal resistance ($R_N$) in a range from 1/20 to 1/200.

5. A device as claimed in claim 4, **characterized in that** the stabilizer circuit arranged as a loop comprises in a first branch a first amplifier (A1) which receives the reference voltage ($V_{CON}$) and which controls the resistance of the transistor (T) arranged as a variable resistor, and which includes in a second branch a second amplifier having a predetermined gain (G) whose input terminals are connected to the terminals of said small resistance (r) and whose output is connected as a second input to the first amplifier (A1), the gain (G) of the second amplifier being predetermined so that the product of this gain (G) and the value of said small resistance (r) is equal to the value of the nominal resistance ($R_N$).

6. A device as claimed in one of the claims 1 to 5, **characterized in that** the value of the nominal resistance ($R_N$) is the average of the internal resistances ($R_{PA}$) of a manufactured batch of amplifier circuits of the same type.

7. A device as claimed in claim 6, **characterized in that** the power amplifiers of the manufactured batch of power amplifiers for realizing the device have predetermined dispersion coefficients in a range ($\alpha_1$, $\alpha_2$) that corresponds to extreme current-voltage characteristics ($D_1$, $D_2$) around the nominal current-voltage characteristic ($D_N$) corresponding to the nominal resistance ($R_N$), these extreme characteristics ($D_1$, $D_2$) being such that the intersections of the characteristics comprised between these extreme characteristics with a straight line ($D_H$) tangential to an exact isopower curve (H) at the point of intersection of this curve (H) and the nominal characteristic curve ($D_n$) determine pairs of current-voltage values substantially coinciding with the pairs of current-voltage values that are situated on the exact isopower curve (H), and **in that** said tangential straight line ($D_H$) is a substantially exact isopower curve so that the pairs of current-voltage values of this straight line result from a constant power consumption of whatever amplifiers of the manufactured batch of amplifiers.

8. A device as claimed in one of the claims 1 to 7, including a power amplifier circuit and a stabilizer circuit in a radio frequency transceiver circuit.

9. A device as claimed in claim 8, realized in gallium arsenide integrated circuit technology (GaAs).

10. A mobile transceiver terminal device including a radio frequency device as claimed in one of the claims 1 to 9.

FIG.1A

FIG.1B

FIG.2A

FIG.2B

FIG.1C

FIG.3

FIG.4

FIG.5